# EUROPÄISCHE PATENTSCHRIFT

(11) **EP 2 510 535 B1**
(45) Veröffentlichungstag und Bekanntmachung des Hinweises auf die Patenterteilung: **26.02.2014**
(21) Anmeldenummer: 10814760.4
(22) Anmeldetag: 10.12.2010
(51) Int. Cl.: H01J 37/147, H01J 37/305, C23C 14/30, C23C 14/54

(54) **ABLENKVORRICHTUNG FÜR ELEKTRONENSTRAHLEN**
MAGNETIC DEFLECTION SYSTEM FOR ELECTRON BEAMS
SYSTÈME DE DÉVIATION DES FAISCEAUX ÉLECTRONIQUES

(30) Priorität: 10.12.2009 DE 102009057486
(43) Veröffentlichungstag der Anmeldung: 17.10.2012
(73) Patentinhaber: Ferrotec GmbH, 72669 Unterensingen (DE)
(72) Erfinder: ZINSSTAG, Jürgen, 70192 Stuttgart (DE); JANS, Cristian, 73249 Wernau (DE)
(74) Vertreter: Hebing, Norbert
(86) Internationale Anmeldenummer: PCT/DE2010/001437
(87) Internationale Veröffentlichungsnummer: WO 2011/069493

(56) Entgegenhaltungen:
- EP-A2- 1 187 169
- DD-A1- 237 526
- US-A- 4 524 717
- US-A- 5 393 984
- US-A1- 2005 017 202
- US-A1- 2007 170 369

## Beschreibung

Die Erfindung bezieht sich auf eine Ablenkvorrichtung für Elektronenstrahlen, insbesondere zum Einsatz in einem Elektronenstrahlverdampfer mit einer ersten, eine Zentralachse aufweisenden magnetischen Ablenkeinheit, mit der ein auf der zentralachse in die Ablenkeinheit eintretender Elektronenstrahl durch ein Magnetfeldsystem einen Parallelversatz zur Zentralachse in einer Versatzebene erfährt, wobei die Stärke des Magnetfeldsystems der magnetischen Ablenkeinheit veränderbar ist, um die Größe des Strahlversatzes zu bestimmen, und mit einer zweiten magnetischen Ablenkeinheit, um den aus der ersten magnetischen Ablenkeinheit austretenden Elektronenstrahl aus der Versatzebene heraus zu lenken.

Eine derartige Ablenkvorrichtung ist im Zusammenhang mit einer Verdampfungsanlage in der DE 35 13 546 A1 beschrieben. Die Verdampfungsanlage weist einen länglichen Tiegel auf, wobei mittels eines sich ändernden Strahlversatzes erreicht wird, dass der Elektronenstrahl pendelnd über Längsabschnitte des Tiegels verfahren wird. Da der Strahlversatz begrenzt ist, sind gegebenenfalls mehrere Elektronenstrahlverdampfer mit jeweils einer solchen Ablenkvorrichtung nebeneinander vorgesehen, um die gesamte Länge des Tiegels zu erfassen. Da die räumlichen Gegebenheiten einer verdampfungsanlage es häufig nicht zulassen, den Elektronenstrahl unmittelbar in den Tiegel zu leiten, wird die Versatzebene, in der der Strahlenversatz erfolgt, oberhalb des Tiegels angeordnet und der Elektronenstrahl unmittelbar oberhalb des Tiegels aus der Versatzebene in den Tiegel, d.h. auf die Oberfläche der dort vorhandenen Schmelze abgelenkt.

Dazu wird ein Magnetfeld längs des Tiegels aufgespannt, dessen Feldlinien parallel zum Tiegel verlaufen. Damit die Ablenkung über die gesamte Länge des Tiegels stets in gleicher Weise erfolgt, muss das Feld genügend homogen gestaltet sein. Es ist aber schwierig, ein solch homogenes Feld mittels weit beabstandeten Ankerplatten eines Elektromagneten zu realisieren.

Außerdem soll es möglich sein, den Elektronenstrahlverdampfer unter den vorbeilaufenden Substraten anzuordnen, wobei die verwendete Hochspannung 10 kV nicht überschreiten soll, um Röntgenstrahlung zu vermeiden.

Die US 4,524,717 A zeigt eine Vorrichtung zum Beschichten von bandförmigen Substraten, bei der zur Erzeugung eines Beschichtungsdampfes eine Elektrodenkanone eingesetzt wird, deren Elektronenstrahl pendelnd auf einen länglichen Tiegel gerichtet wird. Zum Führen des Strahls über den Tiegel ist eine erste Ablenkvorrichtung vorhanden, die den Strahl seitlich versetzt sowie eine zweite Ablenkvorrichtung, mit der der Strahl nach unten in den Tiegel abgelenkt wird. Die Magnetlinien der zweiten Ablenkvorrichtung erstrecken sich quer zur Längsausdehnung des Tiegels und sind gleich bleibend über die gesamte Länge des Tiegels vorgesehen. Damit eine stets gleich starke Ablenkung des Elektronenstrahls nach unten in den Tiegel erfolgt, muss der Elektronenstrahl unabhängig von seinem Versatz in der ersten Ablenkvorrichtung unter einem gleich bleibenden Winkel schräg in das Magnetfeld der zweiten Ablenkvorrichtung eintreten. Magnetfelder, die diesen Anforderungen genügen, sind nur mit einem hohen Aufwand zu realisieren.

Ein weiteres Beispiel einer Ablenkvorrichtung ist bekannt aus US 5.393.984.

Die Erfindung beruht damit auf der Aufgabe, eine (zweite) Ablenkeinheit zu schaffen, bei der die Ablenkung aus einer Versatzebene über die gesamte Länge des Tiegels möglichst gleichartig erfolgt.

Zur Lösung des Problems sieht die Erfindung vor, dass die zweite magnetische Ablenkeinheit ein quer zur Zentralachse verlaufendes Magnetfeld generiert, dessen homogener Bereich kürzer ist als der maximale Versatz, der mit der ersten Ablenkeinheit zu erzielen ist, wobei die Lage dieses Magnetfeldes quer zur Zentralachse synchron zum Strahlversatz veränderbar ist.

Ein Magnetfeld, dessen Lage veränderbar ist, lässt sich dadurch realisieren, dass eine Vielzahl von Luftspulen vorgesehen werden, die auf einer Achse nebeneinander angeordnet sind. Die einzelnen Luftspulen sind unabhängig voneinander mit Strom zu beaufschlagen, so dass bei einer sukzessiven Beaufschlagung der Spulen mit Strom das Magnetfeld von Luftspule zu Luftspule wandert.

Ein luftspulenerzeugtes magnetisches Feld ist aber nicht ausreichend stark, um den Elektronenstrahl in gewünschter Weise abzulenken. Deswegen ist ein magnetischer Kern vorgesehen, der auf der Achse verschiebbar gehalten ist. Der magnetische Kern hat in etwa die Länge einer Luftspule, er folgt der jeweils mit Strom beaufschlagten Spule und verstärkt das darin befindliche Magnetfeld in bekannter Weise.

Es liegt damit ein ausreichend starkes Magnetfeld im Bereich des Kernes vor, wobei dieses verstärkte Feld räumlich begrenzt ist. Da die Luftspulen identisch aufgebaut sind, lässt sich somit an jeder Stelle des Luftspulensystems ein gleichartiges Magnetfeld zur Ablenkung eines Elektronenstrahles aufbauen.

Im einfachsten Fall sind die Spulen auf einem Führungsrohr nebeneinander angeordnet und der Kern innerhalb des Führungsrohres geführt, wobei sein Durchmesser in etwa dem Innendurchmesser des Führungsrohres entspricht. Die Schmierung des Kernes erfolgt vorzugsweise mit einer magnetischen Flüssigkeit.

vorzugsweise ist das Führungsrohr zur Vermeidung von Wirbelströmen in Längsrichtung geschlitzt ausgeführt.

Die Luftspulen werden nun zeitlich versetzt und ggf. zeitlich überlappend jeweils mit Strom beaufschlagt, dessen Stromstärke einen auf- und abschwellenden Kurvenverlauf, z. B. einen Sägezahn- oder Glockenformverlauf aufweist, so dass immer zumindest gerade die Luftspule mit einem maximalen Strom versorgt ist, über der sich der Elektronenstrahl aktuell befindet. Wandert der Elektronenstrahl wegen der Ansteuerung der ersten Ablenkeinheit weiter in Längsrichtung des Tiegels zur nächsten Luftspule, so wird mit einer entsprechenden Ansteuerung ein Magnetfeld in dieser Luftspule erzeugt, so dass sich der Elektronenstrahl erneut in einem Magnetfeld befindet, das ihn in den Tiegel ablenkt. Der Eisenkern folgt dem durch die Luftspulen wandernden Magnetfeld und gewährleistet jeweils die notwendige Feldstärke zum Umlenken des Elektronenstrahls. So wird erreicht, dass der Elektronenstrahl in Längsrichtung des Tiegels über der Schmelze hin und her gewobbelt werden kann und immer im gleichen Einfallswinkel auf das zu verdampfende Material trifft.

Die Erfindung bewirkt, dass durch die Synchronisation der ersten und der zweiten Ablenkeinheit Verweilzeiten auf dem Verdampfergut und damit eine Beschichtungsgleichmäßigkeit einstellbar ist. Weiter erlaubt die Einstellung der Stärke des Magnetfeldes der Luftspulen auch ein Wobbeln des Elektronenstrahls quer zur Längsachse des Tiegels, womit auch optische Materialien verdampft werden können, die zum Teil sublimieren.

Das Magnetfeldsystem der ersten Ablenkeinheit, die den Strahlversatz hervorruft, besteht vorzugsweise aus zwei hintereinander angeordneten und antiparallel ausgerichteten Magnetfeldern. Senkrecht zu den Magnetfeldlinien verläuft die Versatzebene. Solche Vorrichtungen sind an sich bekannt. Der Elektronenstrahl tritt in der Versatzebene auf der in der Versatzebene liegenden Zentralachse in das erste Magnetfeld ein und wird je nach Stärke des Magnetfeldes in der Versatzebene nach links oder rechts um einen Winkel abgelenkt.

Da das zweite Magnetfeld antiparallel zum ersten Magnetfeld verläuft, wird der Elektronenstrahl darin um den gleichen Winkel zurückgelenkt, so dass insgesamt ein paralleler Versatz des Elektronenstrahls bewirkt wird. Damit lässt sich z. B. durch eine sinusförmige Änderung des Erregerstroms der Elektromagneten, die die jeweiligen Felder erzeugen, ein pendelnder Versatz des Elektronenstrahls erreichen.

Üblicherweise werden die Magnetfelder in der Projektion auf die Versatzebene rechteckig gestaltet, weil dies durch relativ einfach, nämlich rechteckig geformte Ankerplatten für die Elektromagnete erreicht werden kann. Der Bereich homogen verlaufender Feldlinien ist daher durch eine rechteckig verlaufende Magnetfeldgrenze begrenzt. Der Nachteil dabei ist, dass der Elektronenstrahl schräg zur Magnetfeldgrenze aus dem ersten Magnetfeld austritt und ebenso schräg in das zweite Magnetfeld eintritt. Dadurch treten Streueffekte auf, die den Elektronenstrahl aufweiten. Es wird daher erfindungsgemäß vorgeschlagen, dass die Magnetfeldgrenze des ersten Magnetfeldes an der Austrittsseite konvex und die Magnetfeldgrenze des zweiten Magnetfeldes an der Eintrittsseite konkav verläuft.

Der Verlauf wird möglichst so gewählt, dass der Elektronenstrahl an jeder Stelle, an der er aus dem ersten Magnetfeld austritt bzw. in das zweite Magnetfeld eintritt, die Tangente an der Magnetfeldgrenze senkrecht durchläuft. Streueffekte werden dadurch vermieden, so dass der Elektronenstrahl nur wenig oder gar nicht aufgeweitet wird.

Eine solche magnetische Ablenkeinheit, die einen Strahlversatz erzeugt, wird mit den Merkmalen des Anspruches 7 definiert. Demnach werden die Magnetfelder aus jeweils zwei parallel verlaufenden Ankerplatten eines Elektromagneten gebildet. Um den oben beschriebenen Verlauf der Magnetfeldgrenzen zu erreichen, weisen die gegenüberliegenden Kanten der Ankerplatten parallele, aber gekrümmt verlaufende Kanten auf.

Gegenstand der Erfindung ist auch eine Vorrichtung zum Bedampfen eines flächigen Substrats, z. B. einer Folie, mit einer dünnen Materialschicht, bei der das Substrat über einen länglichen Tiegel geführt wird, so dass das Substrat jeweils über seine Breite bedampft wird.

Das Beschichten von großflächigen Substraten, wie Architekturglas, Folien etc. erfolgt im Allgemeinen in sogenannten Durchlaufanlagen, bei denen Material mit einem Sputterprozess auf die Substrate aufgebracht wird. Die Sputterquellen werden unter den durchlaufenden Substraten als Linearquellen positioniert, damit die durchlaufenden Substrate von unten beschichtet werden können. Wenn jedoch die Beschichtung unter Einsatz eines kommerziellen Elektronenstrahlverdampfers mit 270 Grad Strahlablenkung erfolgt und um bessere Beschichtungsraten zu erreichen, sind auf Grund der Geometrie der Anlage nur sehr schwer gleichmäßige Beschichtungen zu erreichen, da bei großen Substratbreiten mehrere Elektronenstrahlverdampfer nebeneinander verwendet werden müssen. Da diese das Material nur punktförmig treffen, sind mehrere Blenden unterhalb der Substrate und ein großer Substratabstand notwendig, um eine gleichmäßige Schichtdickenverteilung auf den Substraten zu erreichen. Wegen der tagelangen Betriebsdauer solcher Durchlaufanlagen werden diese Blenden so stark bedampft, dass ein Austauschen der Blenden und damit eine Unterbrechung des Prozesses nach wenigen Stunden notwendig würde. Daher kommen bisher bekannte konventionelle Elektronenstrahlverdampfer für diese Anwendung nicht zum Einsatz. Zwar sind kommerzielle Elektronenstrahlverdampfer auf dem Markt, die von schräg oben auf das zu verdampfende Material gerichtet werden. Diese Elektronenstrahlverdampfer haben aber den Nachteil, dass sie nicht für Durchlaufanlagen geeignet sind, da die Elektronenstrahlkanone oberhalb des Tiegels anzuordnen wäre und damit selbst beschichtet werden würde.

Die Materialverdampfung erfolgt mit Hilfe einer Elektronenstrahlkanone.

Um eine kompakt aufgebaute Vorrichtung zu erhalten, bei der die Materialverdampfung mit Hilfe einer Elektronenstrahlkanone erfolgt, ist diese unterhalb des Transportweges für das Substrat angeordnet und auf diesen gerichtet. Die Anordnung kann ggf. auch noch unterhalb des Tiegels erfolgen. Eine dritte Ablenkeinheit lenkt dazu den auf das Substrat gerichteten Elektronenstrahl in etwa parallel zum Transportweg. Innerhalb dieses parallel zum Transportweg verlaufenden Abschnittes des Elektronenstrahls befindet sich die oben beschriebene erste Ablenkeinheit, um einen sich ändernden Strahlversatz zu erzeugen. Danach wird der Elektronenstrahl mit Hilfe der dritten Ablenkeinheit in den Tiegel gelenkt, so dass der Elektronenstrahl möglichst senkrecht auf die Schmelzenoberfläche trifft.

Die dritte Ablenkeinheit kann wie oben beschrieben aus einer axialen Aneinanderreihung von Luftspulen bestehen, in denen ein magnetischer Kern hin- und herlaufen kann. Es können sowohl eine Luftspulenreihe, vorzugsweise in Strahlrichtung gesehen vor dem Tiegel, aber auch zwei oder mehrere Luftspulenreihen vorgesehen werden, die vorzugsweise vor und/oder hinter dem Tiegel angeordnet sind. Bei einer solchen doppelten Anordnung von Luftspulenreihen kann durch eine geeignete Ansteuerung der Luftspulen erreicht werden, dass der Elektronenstrahl in Strahlrichtung gewobbelt wird, also nicht nur längs zum Tiegel, sondern auch quer dazu abgelenkt wird, so dass auch bei einem breiten Tiegel die gesamte Oberfläche sukzessive vom Elektronenstrahl abgefahren wird.

Mit der ersten Ablenkeinheit wird, wie erläutert, ein Parallelversatz erzeugt, so dass der Elektronenstrahl stets senkrecht zur Längsausdehnung des Tiegels auf diesen zuläuft. Da durch die erläuterte Gestaltung der zweiten Ablenkeinheit im aktuellen Bereich des Strahleintritts in die Tiegelzone ein ausreichend starkes und gleichbleibendes Magnetfeld erzeugt wird, wird jeder Elektronenstrahl unabhängig von seiner Lage in Bezug auf die Längsausdehnung des Tiegels in gleicher Weise in den Tiegel abgelenkt. Es ergibt sich somit ein hochgenaues Ablenksystem, das eine über die Länge des Tiegels gleichmäßige Verdampfungsrate ermöglicht.

Im Folgenden soll anhand eines Ausführungsbeispieles die Erfindung näher erläutert werden. Dazu zeigen:
- Fig.1: eine vorrichtung zum Bedampfen eines flächigen Substrats, z. B. einer Folie,
- Fig.2a: eine Draufsicht auf eine magnetische Ablenkeinheit, die dem parallelen Versatz eines Elektronenstrahls dient,
- Fig.2b: eine Seitenansicht der magnetischen Ablenkeinheit nach Fig. 2a,
- Fig.3: eine magnetische Ablenkeinheit mit einem lageveränderlichen Magnetfeld,
- Fig.4: eine prinzipielle Darstellung der synchronen Ansteuerung der Ablenkeinheiten nach Fig. 2 und 3 sowie
- Fig.5: einen Querschitt durch einen magnetischen Kern, der für die magnetische Ablenkeinheit nach Fig. 3 benötigt wird.

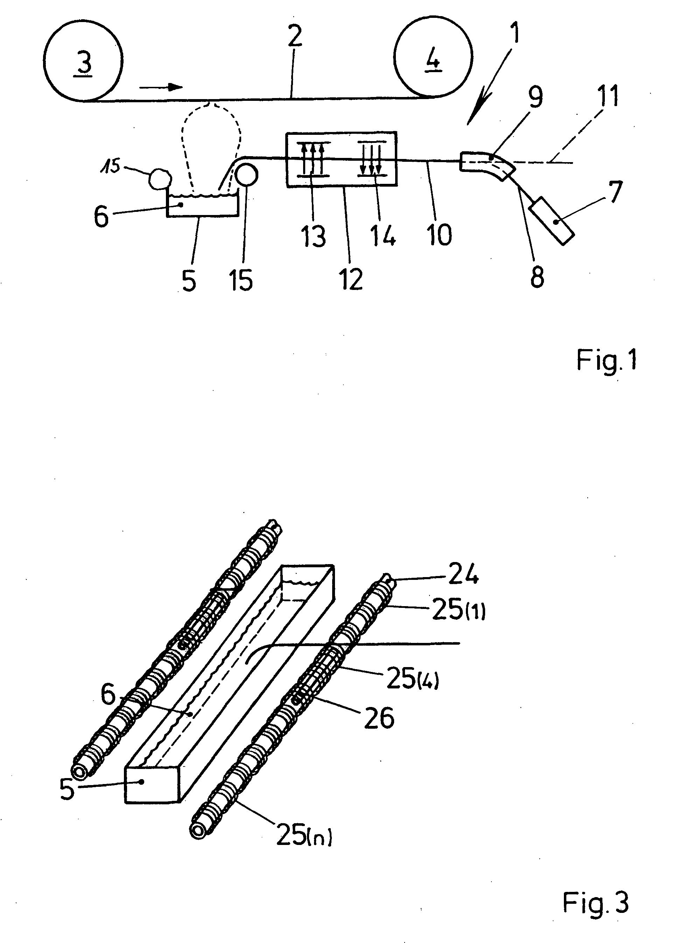

Die Fig. 1 zeigt in prinzipieller Darstellung eine vorrichtung 1 zum Bedampfen eines flächigen Substrats 2, z. B. einer Folie. Die Folie wird von einer ersten Rolle 3 abgewickelt und auf eine zweite Rolle 4 aufgewickelt. Dabei wird sie über einen quer zum Transportweg verlaufenden Tiegel 5 geführt. In dem Tiegel 5 befindet sich eine Schmelze 6 aus dem Material, das auf die Folie gedampft werden soll. Zum Einschmelzen und Verdampfen des Materials sind mehrere Elektronenstrahlkanonen 7 vorgesehen, die nebeneinander parallel zum Tiegel 5 angeordnet sind. Jede Elektronenstrahlkanone 7 - von denen eine dargestellt ist - ist für einen bestimmten Abschnitt des Tiegels bezogen auf seine Längsausdehnung bestimmt, indem der zugehörige Elektronenstrahl 8 mit Hilfe weiter unten beschriebener magnetischer Ablenkeinheiten pendelnd über diesen Abschnitt geführt wird.

Im Folgenden wird die Strahlablenkung anhand einer Elektronenstrahlkanone 7 näher erläutert. Jede weitere Elektronenstrahlkanone weist eine entsprechende Strahlablenkung auf.

Die Elektronenstrahlkanone ist so ausgerichtet, dass der Elektronenstrahl 8 zunächst auf das Substrat 2 zielt. Der Elektronenstrahl 8 wird aber durch eine dritte Ablenkeinheit 9 in eine Ebene parallel zum Substrat 2 abgelenkt, die gleichzeitig eine Versatzebene 10 bildet, in der der Stahl einen pendelnden Parallelversatz gegenüber einer Zentralachse 11 erfährt.

Die dritte Ablenkeinheit 9 ist von einer üblichen Bauart und soll hier nicht näher erläutert werden. In der Regel bildet diese zusammen mit der Elektronenstrahlkanone eine Baueinheit.

Zur Erzeugung eines pendelnden Parallelversatzes befindet sich in der Versatzebene eine aus einem Magnetfeldsystem bestehende erste Ablenkeinheit 12, die aus zwei hintereinander angeordneten Magnetfeldern 13, 14 besteht, die weiter unten noch näher erläutert werden, wobei das erste Magnetfeld 13 den Elektronenstrahl 8 um einen Winkel in der Versatzebene 10 nach links bzw. rechts ablenkt und in dem zweiten Magnetfeld 14 dieser Winkelversatz gerade kompensiert wird, so dass der Elektronenstrahl 8 parallel zur ursprünglichen Richtung aus dem Magnetfeldsystem heraustritt.

Im Bereich des Tiegels 5 befindet sich eine zweite Ablenkeinheit 15, die den Elektronenstrahl 8, der ansonsten über den Tiegel 5 verlaufen würde, aus der Versatzebene 10 heraus in den Tiegel 5 ablenkt.

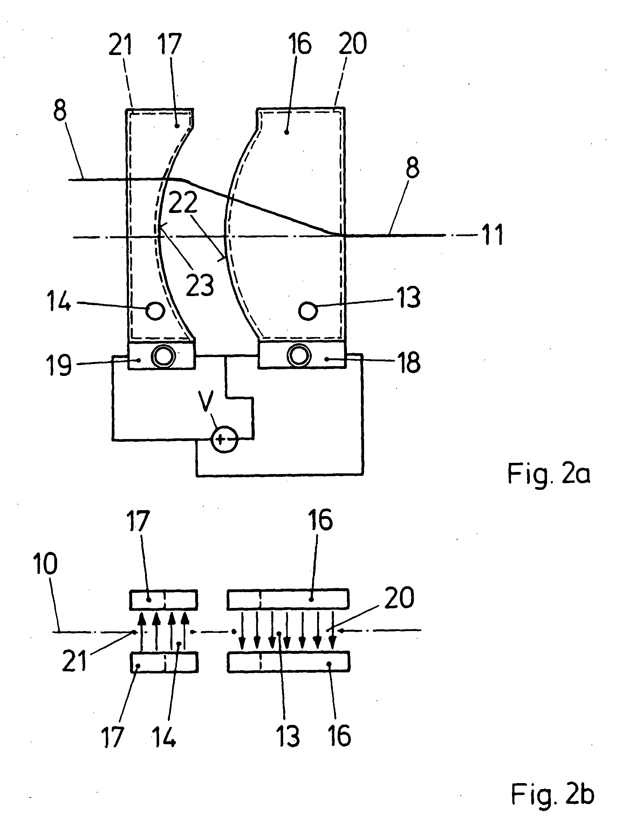

Die erste Ablenkeinheit 12 ist der Fig. 2a in einer Draufsicht und in Fig. 2b in einer Seitenansicht dargestellt.

Die Magnetfelder 13, 14 werden von zwei übereinander angeordneten, parallel verlaufenden Ankerplatten 16 bzw. 17 eines Elektromagneten 18 bzw. 19 erzeugt, zwischen denen der Elektronenstrahl 8 verläuft. Richtung und Stärke der Magnetfelder 13, 14 werden durch die Polarität und Stärke des Spulenstroms für den jeweiligen Elektromagneten 18 bzw. 19 bestimmt. Da die Magnetfeldlinien im senkrecht auf die Ankerplatten 16 bzw. 17 stoßen, ist das jeweilige Magnetfeld 13, 14 auf den Bereich zwischen den Ankerplatten 16 bzw. 17 begrenzt. Die Magnetfeldgrenze 20, 21, das ist die Einhüllende des jeweiligen Magnetfeldes 13, 14 bezogen auf eine mittlere Ebene zwischen den Ankerplatten 16 bzw. 17, wird daher durch die Ankerplattenform bestimmt.

Die Kanten der Ankerplatten 16 des ersten Magnetfeldes 13 sind an der Eintrittsseite gerade und verlaufen senkrecht zum Elektronenstrahl 8. Dieser wird im ersten Magnetfeld 13 je nach Richtung und Stärke des Magnetfeldes 13 nach links oder rechts abgelenkt und tritt an der Austrittsseite aus. Damit der Strahlaustritt senkrecht zu der an der Austrittsstelle verlaufenden Tangente an der Magnetfeldgrenze 20 erfolgt, sind die hinteren Kanten 22 der Ankerplatten 16 des ersten Magnetfeldes 13 konvex geführt.

Die Ankerplatten 17 des zweiten Magnetfeldes 14 sind entsprechend aufgebaut, nur sind ihre vorderen Kanten 23 konkav ausgebildet, so dass auch der Eintritt des Elektronenstrahls 8 jeweils senkrecht zur Tangente an der Magnetfeldgrenze 21 erfolgt. Die hinteren Kanten des zweiten Magnetfeldes 14 sind wieder gerade geführt, so dass auch hier ein senkrechter Austritt zur Magnetfeldgrenze vorliegt.

Der jeweilige senkrechte Ein- bzw. Austritt durch die Magnetfeldgrenzen 20, 21 hat den Vorteil, dass der Elektronenstrahl 8 nur wenig oder gar nicht aufgeweitet wird. Es lässt sich somit ein exakter Strahlenversatz ohne Strahlaufweitung realisieren.

Bei einer entsprechenden Wahl der geometrischen Ausdehnung der Ankerplatten 16, 17 bzw. der Anzahl der Windungen der Spulen der Elektromagnete 18, 19, lässt sich erreichen, dass die sich kompensierenden Strahlablenkungen jeweils mit der gleichen Stromstärke erzielt werden, so dass für beide Magnetfelder 13, 14 eine gemeinsame Spannungsquelle V vorgesehen werden kann, an der diese nur antiparallel angeschlossen werden müssen.

Wie in Fig. 1 gezeigt, soll der versetzte Elektronenstrahl 8 schließlich aus der Versatzebene 10 in den Tiegel 5 ausgelenkt werden. Dies wird gemäß der Fig. 3 dadurch erreicht, dass auf einem Führungsrohr 24, das parallel zum Tiegel 5 verläuft, dicht nebeneinander mehrere Luftspulen 25, die mit (1) bis (n) nummeriert sind, aufgesteckt werden, die einzeln angesteuert werden. Die Luftspulen bilden eine Luftspulenreihe. Nur aus Übersichtsgründen sind die einzelnen Luftspulen 25 mit einem kleinen Abstand zueinander dargestellt. Die Ansteuerung der Luftspulen 25 wird mit dem Strahlversatz so synchronisiert, dass immer gerade die Luftspule 25 mit Strom versorgt wird, in deren Abschnitt der Elektronenstrahl 8 auf den Tiegel 5 zuläuft.

Das Magnetfeld einer Luftspule 25 würde nicht ausreichen, um den Elektronenstrahl 8 genügend stark, also um mindestes 60° bis 90° abzulenken. Daher befindet sich im Führungsrohr 24 ein magnetischer zylinderförmiger Kern 26, der dort mit Hilfe einer magnetischen Schmierung verschiebbar gelagert ist.

Da der Kern 26 durch das jeweils in einer Luftspule 25 vorliegende magnetische Feld magnetisiert wird, wird er in die aktuell mit Strom beaufschlagte Luftspule 25, in der Darstellung ist dies die Luftspule 25 (4), hineingezogen. Der Kern 26 wandert also entsprechend der Beaufschlagung der einzelnen Spulen mit Strom. Da durch den Kern 26 das außerhalb der Luftspule 25 verlaufende Magnetfeld gerade in dem Bereich der jeweils angesteuerten Spule verstärkt wird, ist ein ausreichend starkes Magnetfeld somit auf den Abschnitt beschränkt, in dem sich aktuell die mit Strom beaufschlagte Luftspule befindet.

Da die Abmessung der Luftspulen 25 klein ist, lässt sich im Bereich einer Luftspule 25 jeweils ein homogenes Magnetfeld realisieren, das aber entsprechend der Spulenansteuerung parallel zum Tiegel verschoben wird. Somit wird jeder Elektronenstrahl 8 unabhängig von seiner Eintrittsstelle in gleicher Weise abgelenkt.

Die Ansteuerung der Luftspulen 25 (n) kann sukzessiv erfolgen, sie kann aber auch überlappend erfolgen, so dass in dem Maße, wie die Stromzufuhr zu einer Luftspule 25 (n) abnimmt, die nachfolgende Spule 25 (n+1) bzw. 25 (n-1) mit Strom beaufschlagt wird.

Wie die Fig. 1 und 3 zeigen, wird die zweite Ablenkeinheit 15 aus zwei sich parallel zum Tiegel 5 erstreckenden Luftspulenreihen gebildet, wobei eine vor und eine hinter dem Tiegel 5 angeordnet ist. Die Luftspulenreihen sind identisch aufgebaut und werden synchron, aber jeweils mit einer unterschiedlichen und sich zyklisch ändernden Stromstärke betrieben, so dass der Elektronenstrahl auch quer zur Längserstreckung des Tiegels abgelenkt wird, also über die Breite des Tiegels 5 gewobbelt wird.

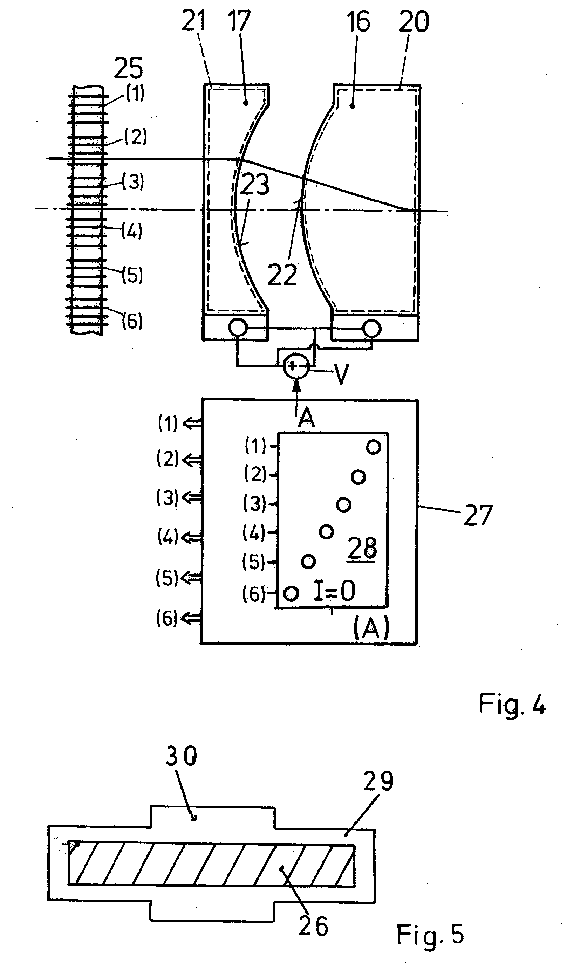

In der Fig. 4 ist das magnetische Ablenksystem noch einmal prinzipiell dargestellt. Man erkennt die beiden Ankerplatten 16, 17 der ersten magnetischen Ablenkeinheit und mehrere Luftspulen 25n (n = 1, 2..) der zweiten Ablenkeinheit 15 zum Ablenken des Elektronenstrahls 8 aus der Versatzebene 10. Die Steuerung der Stärke des Versatzes, d. h. die Stärke der antiparallelen Magnetfelder 13, 14 ist derart mit der Ansteuerung der Luftspulen 25 (n = 1, 2, 3 ...) gekoppelt, dass der Elektronenstrahl 8 stets über eine mit Strom beaufschlagte Luftspule 25 (n) verläuft und durch deren durch den Kern verstärktes Magnetfeld aus der Versatzebene 10 abgelenkt wird. Die Kopplung erfolgt mittels einer Steuerung 27, in der z. B. mittels einer Tabelle 28 eine entsprechende Zuordnung zwischen der Stromstärke A des Spulenstroms für die Elektromagnete 18, 19 und der jeweils anzusteuernden Luftspule 25n abgelegt ist. Statt einer Tabelle kann auch eine analoge elektronische Schaltung (hier nicht dargestellt) vorgesehen werden.

Wenn der Tiegel 5 besonders lang ist, werden mehrere Elektronenkanonen benötigt, die mit jeweils einem Ablenksystem wie oben beschrieben zusammenwirken. Damit die Bewegungsbahn auf der Schmelzenoberfläche des einen Elektronenstrahls dort endet, wo die Bewegungsbahn des benachbarten Elektronenstrahls beginnt, muss der magnetische Kern jeweils die beiden letzten Spulen einer Spulenreihe vollständig ausfüllen und möglichst noch ein wenig aus der Spule herausragen. Um dies zu erreichen, wird - wie in Fig. 5 gezeigt - der magnetische Kern 26 in einer Hülse 29 angeordnet, die mittig eine Verdickung 30 aufweist. An den Enden des Führungsrohres sind Anschläge für die verdickung 30 vorgesehen, die zwar zulassen, dass ein Ende des magnetischen Kerns 26 aus der Spule 25 (1) bzw. 25 (n) herausragt, aber nicht darüber hinausfährt und somit die Mitte des magnetischen Kerns 26 an den äußeren Rand der äußeren Luftspulen heranreicht.

**Bezugszeichenliste**

| | | | |
|---|---|---|---|
| 1 | Vorrichtung | 21 | Magnetfeldgrenze |
| 2 | Substrat | 22 | Kanten |
| 3 | Rolle | 23 | Kanten |
| 4 | Rolle | 24 | Führungsrohr |
| 5 | Tiegel | 25 | Luftspulen |
| | | | |
| 6 | Schmelze | 26 | Kern |
| 7 | Elektronenstrahlkanone | 27 | Steuerung |
| 8 | Elektronenstrahl | 28 | Tabelle |
| 9 | dritte Ablenkeinheit | 29 | Hülse |
| 10 | Versatzebene | 30 | verdickung |
| | | | |
| 11 | Zentralachse | | |
| 12 | erste Ablenkeinheit | | |
| 13 | erstes Magnetfeld | | |
| 14 | zweites Magnetfeld | | |
| 15 | zweite Ablenkeinheit | | |
| | | | |
| 16 | Ankerplatten | | |
| 17 | Ankerplatten | | |
| 18 | Elektromagnet | | |
| 19 | Elektromagnet | | |
| 20 | Magnetfeldgrenze | | |

## Patentansprüche

1. Ablenkvorrichtung für Elektronenstrahlen, insbesondere zum Einsatz in einem Elektronenstrahlverdampfer, mit einer ersten, eine Zentralachse aufweisenden magnetischen Ablenkeinheit (12), die so ausgebildet ist, dass ein auf der Zentralachse (11) in die Ablenkeinheit (12) eintretender Elektronenstrahl (8) durch ein Magnetfeldsystem einen Parallelversatz zur Zentralachse (11) in einer Versatzebene (10) erfährt, wobei die Stärke des Magnetfeldsystems der magnetischen Ablenkeinheit veränderbar ist, um die Größe des Strahlversatzes zu bestimmen, und mit einer zweiten magnetischen Ablenkeinheit (15), die so ausgebildet ist, um den aus der ersten magnetischen Ablenkeinheit (12) austretenden Elektronenstrahl (8) aus der Versatzebene (10) heraus zu lenken, **dadurch gekennzeichnet, dass** die zweite magnetische Ablenkeinheit (15) so ausgebildet ist, dass sie ein quer zur Zentralachse (11) verlaufendes Magnetfeld generiert, dessen homogener Bereich kürzer ist als der maximale Versatz, der mit der ersten Ablenkeinheit (12) zu erzielen ist, und mit einer Steuerung (27) für die zweite magnetische Ablenkeinheit (15), mit der die Lage dieses Magnetfeldes quer zur Zentralachse (11) synchron zum Strahlversatz veränderbar ist.

2. Ablenkvorrichtung nach Anspruch 1, **dadurch gekennzeichnet, dass** die zweite Ablenkeinheit (15) aus einer Vielzahl von auf einer Achse angeordneten Luftspulen (25n) besteht, die einzeln ansteuerbar sind, und dass ein magnetischer Kern (26) auf der Achse verschiebbar gehalten ist.

3. Ablenkvorrichtung nach Anspruch 2, **dadurch gekennzeichnet, dass** mehrere Luftspulen (25n) auf einem vorzugsweise geschlitzten Führungsrohr (24) nebeneinander angeordnet sind und der Kern (26) eine zylindrische Form hat, dessen Außendurchmesser in etwa dem Innendurchmesser des Führungsrohres (24) entspricht.

4. Ablenkvorrichtung nach Anspruch 3, **dadurch gekennzeichnet, dass** zwischen dem Kern (26) und dem Führungsrohr (24) eine Schmierung mit einer magnetischen Flüssigkeit erfolgt.

5. Ablenkvorrichtung nach einem der vorhergehenden Ansprüche, **dadurch gekennzeichnet, dass** das Magnetfeldsystem aus zwei hintereinander angeordneten und antiparallel ausgerichteten Magnetfeldern (13, 14) besteht.

6. Ablenkvorrichtung nach Anspruch 5, **dadurch gekennzeichnet, dass** die Magnetfeldgrenze (20) des ersten Magnetfelds (13) an der Austrittsseite konvex und die Magnetfeldgrenze (21) des zweiten Magnetfeldes (14) an der Eintrittsseite konkav verläuft.

7. Ablenkvorrichtung nach Anspruch 6, **dadurch gekennzeichnet, dass** die zwei hintereinander angeordneten und antiparallel ausgerichteten Magnetfelder (13, 14) jeweils aus parallel verlaufenden Ankerplatten (16, 17) eines Elektromagneten (18, 19) bestehen, wobei die gegenüberliegenden Kanten (22, 23) der Ankerplatten (16) zur Erzeugung des ersten Magnetfelds (13) und der der Ankerplatten (17) zur Erzeugung des zweiten Magnetfeldes (14) parallel gekrümmt verlaufen.

8. Vorrichtung zum Bedampfen eines flächigen Substrates mit einer Ablenkvorrichtung nach einem der vorhergehenden Ansprüche, **dadurch gekennzeichnet, dass** die Vorrichtung einen länglichen Tiegel (5), der zu verdampfendes Material enthält, einen Transportweg, auf dem das flächige Substrat (2) über den Tiegel (5) transportiert wird, und wenigstens eine Elektronenstrahlkanone (7), deren Elektronenstrahl (8) in den Tiegel (5) gelenkt ist, aufweist, wobei die erste magnetischen Ablenkeinheit (erste Ablenkeinheit 12) den Elektronenstrahl (8) pendelnd über einen Längsabschnitt des Tiegels (5) fährt, und wobei die Elektronenstrahlkanone (7) und die erste Ablenkeinheit (12) sich auf der Seite des Transportweges befinden, auf der auch der Tiegel (5) angeordnet ist.

9. Vorrichtung nach Anspruch 8, **dadurch gekennzeichnet, dass** der Elektronenstrahl (8) der Elektronenstrahlkanone (7) auf den Transportweg gerichtet ist und mittels einer Ablenkeinheit (dritte Ablenkeinheit 9) im Wesentlichen parallel zum Transportweg umgelenkt wird und dass die erste Ablenkeinheit (12) auf dem im Wesentlichen parallel verlaufenden Abschnitt der Elektronenstrahlpfades angeordnet ist.

10. Vorrichtung nach Anspruch 9, **dadurch gekennzeichnet, dass** die zweite Ablenkeinheit (15) den im Wesentlichen parallel zum Transportweg verlaufenden Elektronenstrahl (8) in den Tiegel lenkt, wobei diese Ablenkeinheit (15) aus mehreren nebeneinander auf einer Achse angeordneten Luftspulen (25n) besteht, und wobei die Achse parallel zur Längsausdehnung des Tiegels (5) verläuft.

11. Vorrichtung nach Anspruch 9, **dadurch gekennzeichnet, dass** die zweite Ablenkeinheit (15) in Strahlrichtung gesehen vor und/oder hinter dem Tiegel (5) angeordnet ist.

12. Vorrichtung nach Anspruch 9, **dadurch gekennzeichnet, dass** die zweite Ablenkeinheit (15) in Strahlrichtung gesehen unterhalb des Tiegels (5) angeordnet ist.

## Claims

1. A deflecting device for electron beams, in particular for use in an electron beam vaporizer, the deflecting device comprising a first magnetic deflecting unit (12) having a central axis, wherein the magnetic deflecting unit is configured in such a way that an electron beam (8) entering the deflecting unit (12) on the central axis (11) is displaceable parallel to the central axis in a displacement plane (10) via a magnetic field system, whereby the intensity of the magnetic field system of the magnetic deflecting unit is variable in order to determine the magnitude of the beam displacement, and comprising a second magnetic deflecting unit (15) that is configured in such a way that the electron beam (8) exiting the first magnetic deflecting unit (12) is directed out of the displacement plane (10), **characterized in that** the second magnetic deflecting unit (15) generates a magnetic field running transverse to the central axis (11), the homogeneous area of the magnetic field being shorter than a maximum displacement to be achieved with the first deflecting unit (12), and further comprising a control (27) for the second magnetic deflecting unit (15) with which the position of the magnetic field running transverse to the central axis is variable synchronously with the beam displacement.

2. The deflecting device according to claim 1, **characterized in that** the second deflecting unit (15) comprises a plurality of air core coils (25n) disposed on one axis, the plurality of air core coils being controllable independently, and that a magnetic core (26) is held displaceably on the one axis.

3. The deflecting device according to claim 2, **characterized in that** several air core coils (25n) are disposed next to one another on a preferably slotted guide tube (24) and the core (26) has a cylindrical shape with an outer diameter corresponding approximately to the inner diameter of the guide tube (24).

4. The deflecting device according to claim 3, **characterized in that** a magnetic liquid lubrication is provided between the magnetic core (26) and the guide tube (24).

5. The deflecting device according to one of the preceding claims, **characterized in that** the magnetic field system comprises two tandemly disposed and anti-parallel aligned magnetic fields (13, 14).

6. The deflecting device according to claim 5, **characterized in that** the magnetic field boundary (20) of the first magnetic field (13) runs convexly on the exit side and a magnetic field boundary (21) of the second magnetic field (14) runs concavely on the entry side.

7. The deflecting device according to claim 6, **characterized in that** each of the two tandemly disposed and antiparallel aligned magnetic fields (13, 14) comprises parallel-running armature plates (16, 17) of an electromagnet (18, 19), whereby the opposite edges (22, 23) of the armature plates (16) for generating the first magnetic field (13) and those of the armature plates (17) for generating the second magnetic field (14) run parallel but curved.

8. A device for vaporizing a planar substrate with a deflecting device according to one of the preceding claims, **characterized in that** the device comprises an elongated pot (5) containing material to be vaporized, a transport path on which the planar substrate (2) is transportable over the elongated pot (5), and at least one electron beam gun (7) whose electron beam (8) is deflected into the elongated pot (5), whereby the first magnetic deflecting unit (first deflecting unit 12) drives the electron beam (8) pendularly over a longitudinal section of the elongated pot (5), and whereby the electron beam gun (7) and the first deflecting unit (12) are located on the side of the transport path on which the elongated pot (5) is also disposed.

9. The device according to claim 8, **characterized in that** the electron beam (8) of the electron beam gun (7) is directed onto the transport path and is deflected essentially parallel to the transport path via a deflecting unit (third deflecting unit 9), and **in that** the first deflecting unit (12) is disposed on the essentially parallel-running section of the electron beam path.

10. The device according to claim 9, **characterized in that** the second deflecting unit (15) directs the electron beam (8) running essentially parallel to the transport path into the elongated pot (5), whereby the second deflecting unit (15) comprises several air core coils (25n) disposed next to one another on one axis, and whereby said axis runs parallel to a longitudinal extension of the elongated pot (5).

11. The device according to claim 9, **characterized in that**, viewed in the direction of the beam, the second deflecting unit (15) is disposed in front of and/or behind the elongated pot (5).

12. The device according to claim 9, **characterized in that**, viewed in the direction of the beam, the second deflecting unit (15) is disposed below the elongated pot (5).

## Revendications

1. Dispositif de déviation pour faisceaux d'électrons, en particulier pour l'utilisation dans un vaporisateur à faisceau d'électrons, avec une première unité de déviation magnétique (12) présentant un axe central, laquelle est réalisée de manière à ce qu'un faisceau d'électrons (8) sur l'axe central (11) entrant dans l'unité de déviation (12) soit soumis à un décalage parallèle par rapport à l'axe central (11) dans un plan de décalage (10) grâce à un système à champs magnétiques, moyennant quoi il est possible de faire varier la puissance du système à champs magnétiques de l'unité de déviation magnétique afin de déterminer l'ampleur du décalage du faisceau, et avec une deuxième unité de déviation magnétique (15), laquelle est réalisée afin de guider le faisceau d'électrons (8) sortant de la première unité de déviation magnétique (12) hors du plan de décalage (10), **caractérisé en ce que** la deuxième unité de déviation magnétique (15) est réalisée de manière à générer un champ magnétique s'étendant transversalement à l'axe central (11), dont la zone homogène est plus courte que le décalage maximal à obtenir avec la première unité de déviation (12), et avec une commande (27) pour la deuxième unité de déviation magnétique (15), grâce à laquelle il est possible de modifier la position de ce champ magnétique transversalement à l'axe central (11) de manière synchrone avec le décalage de faisceau.

2. Dispositif de déviation selon la revendication 1, **caractérisé en ce que** la deuxième unité de déviation (15) se compose d'une pluralité de bobines sans fer (25n) disposées sur un axe, lesquelles peuvent être commandées individuellement, et **en ce qu'**un noyau magnétique (26) est maintenu de manière à pouvoir coulisser sur l'axe.

3. Dispositif de déviation selon la revendication 2, **caractérisé en ce que** plusieurs bobines sans fer (25n) sont disposées les unes à côté des autres sur un tube de guidage (24) de préférence fendu, et **en ce que** le noyau (26) a une forme cylindrique dont le diamètre extérieur correspond à peu près au diamètre intérieur du tube de guidage (24).

4. Dispositif de déviation selon la revendication 3, **caractérisé en ce qu'**il y a une lubrification avec un liquide magnétique entre le noyau (26) et le tube de guidage (24).

5. Dispositif de déviation selon l'une des revendications précédentes, **caractérisé en ce que** le système à champs magnétiques se compose de deux champs magnétiques (13, 14) disposés l'un derrière l'autre et orientés antiparallèlement.

6. Dispositif de déviation selon la revendication 5, **caractérisé en ce que** la limite de champ magnétique (20) du premier champ magnétique (13) s'étend de manière convexe du côté de sortie et **en ce que** la limite de champ magnétique (21) du deuxième champ magnétique (14) s'étend de manière concave du côté d'entrée.

7. Dispositif de déviation selon la revendication 6, **caractérisé en ce que** les deux champs magnétiques (13, 14) disposés l'un derrière l'autre et orientés antiparallèlement se composent respectivement de plaques d'induit (16, 17), s'étendant parallèlement, d'un électroaimant (18, 19), les arêtes (22, 23) situées en vis-à-vis des plaques d'induit (16) pour la génération du premier champ magnétique (13) et de celles des plaques d'induit (17) pour la génération du deuxième champ magnétique (14), s'étendant de manière courbée en parallèle.

8. Dispositif pour la vaporisation d'un substrat en nappe avec un dispositif de déviation selon l'une des revendications précédentes, **caractérisé en ce que** le dispositif présente un creuset allongé (5) contenant du matériau vaporiser, un trajet de transport sur lequel le substrat en nappe (2) est transporté via le creuset (5), et au moins un canon à faisceau d'électrons (7) dont le faisceau d'électrons (8) est guidé dans le creuset (5), moyennant quoi la première unité de déviation magnétique (première unité de déviation 12) guide le faisceau d'électrons (8) de manière oscillante au-dessus d'un tronçon longitudinal du creuset (5), et moyennant quoi le canon à faisceau d'électrons (7) et la première unité de déviation (12) se trouvent du côté du trajet de transport, sur lequel le creuset (5) est également disposé.

9. Dispositif selon la revendication 8, **caractérisé en ce que** le faisceau d'électrons (8) du canon à faisceau d'électrons (7) est orienté vers le trajet de transport et est dévié à l'aide d'une unité de déviation (troisième unité de déviation 9) sensiblement parallèlement au trajet de transport et **en ce que** la première unité de déviation (12) est disposée sur le tronçon s'étendant sensiblement parallèlement de la trajectoire du faisceau d'électrons.

10. Dispositif selon la revendication 9, **caractérisé en ce que** la deuxième unité de déviation (15) guide le faisceau d'électrons (8) se propageant sensiblement parallèlement au trajet de transport dans le creuset, moyennant quoi cette unité de déviation (15) se compose de plusieurs bobines sans fer (25n) disposées les unes à côté des autres sur un axe, et moyennant quoi l'axe s'étend parallèlement à l'étendue longitudinal du creuset (5).

11. Dispositif selon la revendication 9, **caractérisé en ce que** la deuxième unité de déviation (15) est disposée, lorsque vue dans le sens du faisceau, devant et/ou derrière le creuset (5).

12. Dispositif selon la revendication 9, **caractérisé en ce que** la deuxième unité de déviation (15), lorsque vue dans le sens du faisceau, est disposée en-dessous du creuset (5).
